# EUROPEAN PATENT SPECIFICATION

(11) **EP 3 467 062 B1**
(45) Date of publication and mention of the grant of the patent: **21.10.2026**
(21) Application number: 17802824.7
(22) Date of filing: 24.05.2017
(51) Int. Cl.: C09J 1/00, C09J 9/02, C09J 11/06, H01B 1/00, H01B 1/22

(54) **ELECTROCONDUCTIVE ADHESIVE**
ELEKTRISCH LEITENDER KLEBSTOFF
ADHÉSIF ÉLECTROCONDUCTEUR

(30) Priority: 26.05.2016 JP 2016104751; 26.05.2016 JP 2016104752; 12.09.2016 JP 2016177408
(43) Date of publication of application: 10.04.2019
(73) Proprietor: Osaka Soda Co., Ltd., Osaka-shi, Osaka 530-0001 (JP)
(72) Inventor: MORI, Takamichi, Osaka-shi Osaka 550-0011 (JP); MINAMI, Junichiro, Osaka-shi Osaka 550-0011 (JP); IWASA, Naruhito, Osaka-shi Osaka 550-0011 (JP)
(74) Representative: Müller-Boré & Partner Patentanwälte PartG mbB
(86) International application number: PCT/JP2017/019311
(87) International publication number: WO 2017/204238

(56) References cited:
- EP-A1- 2 772 328
- WO-A1-2012/133767
- WO-A1-2012/133767
- WO-A1-2013/061527
- WO-A1-2016/125737
- JP-A- 2010 275 580
- JP-A- 2013 214 733
- JP-A- 2015 224 263
- JP-A- 2016 054 098
- US-A1- 2016 121 432

## Description

### TECHNICAL FIELD

The present invention relates to an electroconductive adhesive, a method of manufacturing the electroconductive adhesive, a sintered object of the electroconductive adhesive, and a circuit or an apparatus including the sintered object between members.

### BACKGROUND ART

Electroconductive adhesives such as a die bond and a die attach adhesive are joining materials used in, for example, a semiconductor, an LED, and a power semiconductor. A generally known joining system is joining by pressurization and heating, or joining with a substrate by sintering through, for example, heating without pressurization. In recent years, a non-pressurization joining material is being developed from a viewpoint of its simple and efficient production process.

One example of the non-pressurization joining material is an electroconductive adhesive containing an epoxy resin. This joining material is used by curing the epoxy resin in a low-temperature treatment and is capable of suppressing generation of voids and improving strength of joining with a substrate (Patent Document 1). The epoxy resin itself, however, becomes a resistor to lower electroconductivity and thermal conductivity obtained.

On the other hand, there can be exemplified an electroconductive adhesive only formed of silver as a joining material containing no thermosetting resin such as an epoxy resin. This joining material that contains micro silver or sub-micro silver (particle diameter: 300 to 900 nm) (Patent Document 2) is likely to generate voids and requires a treatment at 200 to 250°C for 1 hour as a normal sintering reaction. Thus, required is development for a joining material that gives high shear strength by a treatment at lower temperature for a short time (material with high joining properties) and is capable of suppressing generation of voids.

In recent years, silver nano fine particles are being developed that have a feature of being easily sintered by a heat treatment at low temperature for a short time. Particularly, silver nano fine particles having a particle diameter of about 20 nm are easily sintered at relatively low temperature (200°C or lower) and are capable of forming a dense film.

Blending many particles with about 20 nm in a joining material, however, generates stress in a coating film according as the coating film increases its film thickness, resulting in generation of cracks and chips. Therefore, development is being required for a material having less stress in a coating film.

As a material that satisfies this requirement, proposed is an electroconductive adhesive containing nanosized metal nano fine particles (for example, see Patent Document 3). Further, Patent Document 4 discloses a thermally conductive composition which comprises silver powder (A), fine silver particles (B), fatty acid silver (C), and an amine (D). Patent Document 5 discloses a composition for bonding, comprising inorganic particles and an organic substance(s) containing amine(s) and/or carboxylic acid(s) adhered onto at least a portion of surfaces of the inorganic particles, wherein a weight reduction rate is 33 % to 69 % upon heating from room temperature to 200°C according to thermal analysis, and the weight reduction rate is 24% to 50% upon heating from 200°C to 300°C. Patent Document 6 discloses a bonding composition containing metal particles, which is capable of achieving high bonding strength by bonding at a relatively low temperature without the application of a pressure.

### PRIOR ART DOCUMENTS

### PATENT DOCUMENTS

Patent Document 1: WO 2010/18712 A1
Patent Document 2: WO 2014/104046 A1
Patent Document 3: Japanese Patent Laid-open Publication No. 2006-83377
Patent Document 4: WO 2012/133767 A1
Patent Document 5: EP 2 772 328 A1
Patent Document 6: US 2016/121432 A1

### SUMMARY OF THE INVENTION

### PROBLEMS TO BE SOLVED BY THE INVENTION

An electroconductive adhesive containing nanosized metal nano fine particles that is disposed between members is heated at high temperature (for example, 200°C or higher) and sintered to form a sintered object capable of exhibiting high electroconductivity while bonding the members.

Studies of the present inventors, however, have found that a conventional electroconductive adhesive containing nanosized silver fine particles gives a sintered object that generates, for example, cracks and chips to decrease the mechanical strength. Particularly, the studies have found that the problem of generating cracks and chips in the sintered object is remarkable, when the heating time is prolonged or the heating temperature is raised during sintering from a viewpoint of further increasing the electroconductivity.

Under these circumstances, a main object of the present invention is to provide an electroconductive adhesive capable of giving a sintered object that is less likely to generate, for example, cracks and chips by sintering and is excellent in mechanical strength. Another object of the present invention is to provide a method of manufacturing an electroconductive adhesive, a sintered object of an electroconductive adhesive, and a circuit or an apparatus including the sintered object between members.

### MEANS FOR SOLVING THE PROBLEMS

The present inventors have conducted earnest studies to solve the above problems. The result of the studies has found that an electroconductive adhesive containing metal fine particles that include a protective layer containing a specific amine and have an average particle diameter in a specific range effectively suppresses cracks and chips on a sintered object of the electroconductive adhesive and is capable of giving a sintered object excellent in mechanical strength. More specifically, the electroconductive adhesive is an electroconductive adhesive containing metal fine particles A that include a protective layer containing an amine and have an average particle diameter of 30 nm to 300 nm, the amine being a monoalkylamine with 5 to 7 carbon atoms, wherein the metal fine particles A include metal fine particles S containing, as the amine contained in the protective layer, a monoalkylamine with 5 to 7 carbon atoms and having an average particle diameter in a range of 180 nm to 210 nm.

The result of the studies has found that this electroconductive adhesive effectively suppresses cracks and chips on a sintered object of the electroconductive adhesive and is capable of giving a sintered object excellent in mechanical strength.

Further, the result of the studies has also found that such a sintered object has high electroconductivity and is excellent in bondability. The present invention has been completed by further repetitively conducting the studies based on such findings.

That is, the present invention provides the aspects as set out in the appended claims.

### ADVANTAGES OF THE INVENTION

According to the present invention, it is possible to provide an electroconductive adhesive capable of giving a sintered object that is less likely to generate, for example, cracks and chips by sintering and is excellent in mechanical strength (shear strength). Further, according to the present invention, it is possible to provide a method of manufacturing the electroconductive adhesive, a sintered object of the electroconductive adhesive, and a circuit or an apparatus including the sintered object between members.

### EMBODIMENTS OF THE INVENTION

An electroconductive adhesive according to the present invention is characterized by containing metal fine particles A that include a protective layer containing an amine and have an average particle diameter of 30 nm to 300 nm, the amine being a monoalkylamine with 5 to 7 carbon atoms, wherein the metal fine particles A include metal fine particles S containing, as the amine contained in the protective layer, a monoalkylamine with 5 to 7 carbon atoms and having an average particle diameter in a range of 180 nm to 210 nm.

Hereinafter, described in detail are the electroconductive adhesive, a method of manufacturing the electroconductive adhesive, a sintered object of the electroconductive adhesive, and a circuit or an apparatus including the sintered object between members according to the present invention.

### 1. Electroconductive adhesive

The electroconductive adhesive according to the present invention contains the metal fine particles A in a predetermined ratio.

### Metal fine particles A

The metal fine particles A of the present invention include a protective layer containing an amine and have an average particle diameter of 30 nm to 300 nm. As described later, the metal fine particles A include the protective layer on a surface layer of particles (metal particles) formed of metal.

The amine contained in the protective layer of the metal fine particles A includes the monoalkylamine with 5 to 7 carbon atoms (hereinafter, sometimes referred to as a "C5-7 monoalkylamine"). Further, the protective layer has a ratio of 100 : 0 between the monoalkylamine with 5 to 7 carbon atoms and an amine different from these amines (total of C5-7 monoalkylamine : total of amine different from C5-7 monoalkylamine).

As the metal fine particles A of the present invention, any metal fine particles having an average particle diameter in the range of 30 nm to 300 nm can be used without particular limitation. The metal fine particles A, however, have an average particle diameter preferably in a range of 30 nm to 250 nm, more preferably in a range of 30 nm to 230 nm. With the metal fine particles A having an average particle diameter of less than 30 nm, it is impossible to obtain sufficient mechanical strength (shear strength), and with the metal fine particles A having an average particle diameter of more than 300 nm, it is impossible to obtain sufficient electroconductivity. The average particle diameter of the metal fine particles A in the present invention include not only cases of using only metal fine particles having an average particle diameter in the above range or combining a plurality of types of metal fine particles having average particle diameters in the above range, but also cases in which a mixture containing metal fine particles having an average particle diameter outside the above range gives an average particle diameter in the above range.

Further, from a viewpoint of allowing the sintered object to exhibit particularly high mechanical strength (shear strength), the metal fine particles A include metal fine particles S containing, as the amine contained in the protective layer, a monoalkylamine (particularly preferably n-hexylamine) with 5 to 7 carbon atoms and having an average particle diameter in a range of 180 nm to 210 nm. The metal fine particles S preferably account for 20% by mass or more of the metal fine particles A.

The amount of the amine contained in the protective layer of the metal fine particles of the present invention can be determined by the measuring method described later.

The metal fine particles A may be substantially formed of only the metal fine particles S (the metal fine particles S account for 99% by mass or more) or may include other metal fine particles. The metal fine particles included together with the metal fine particles S are preferably metal fine particles P containing, as the amine contained in the protective layer, a monoalkylamine (particularly preferably n-hexylamine) with 5 to 7 carbon atoms and having an average particle diameter in a range of 50 nm to 100 nm. The metal fine particles P preferably account for about 20% by mass to about 80% by mass of the metal fine particles A.

When a plurality of types of metal fine particles are used in combination that have average particle diameters in the above range, it is possible to select any types of metal fine particles having average particle diameters in the above range, combine the types of metal fine particles having different average particle diameters, and thus form the metal fine particles A. Examples of the combination of different average particle diameters include a combination of metal fine particles having an average particle diameter of 30 nm or more and less than 100 nm (preferably an average particle diameter in a range of 30 nm or more and less than 100 nm, more preferably an average particle diameter in a range of 50 nm or more and less than 100 nm) (for example, metal fine particles (I) having a small average particle diameter), with metal fine particles having an average particle diameter of 100 nm or more and 300 nm or less (preferably an average particle diameter in a range of 100 nm or more and 250 nm or less, more preferably an average particle diameter in a range of 100 nm or more and 230 nm or less) (for example, metal fine particles (II) having a large average particle diameter). Although the ratio is appropriately selected between types of metal fine particles that have different average particle diameters and are used in combination, the mass ratio (I : II) between the metal fine particles (I) having a small average particle diameter and the metal fine particles (II) having a large average particle diameter may be in a range of 99 : 1 to 1 to 99, preferably in a range of 90 : 10 to 10 : 90, more preferably in a range of 90 : 10 to 20 : 80, further preferably in a range of 90 : 10 to 40 : 60.

Further, as the metal fine particles, it is possible to use metal fine particles having an average particle diameter outside the above range (outside the range of 30 nm to 300 nm, for example, less than 30 nm, 1 to 25 nm, more than 300 nm, about more than 300 nm and about 500 nm or less) in combination. When the metal fine particles having an average particle diameter outside the above range are used in combination, the addition amount of the metal fine particles having an average particle diameter outside the above range is not particularly limited as long as the mixture containing the metal fine particles gives an average particle diameter within the above range. For example, the addition amount may be 15% by mass or less, preferably 10% by mass or less, more preferably 5% by mass or less, relative to the total amount of metal fine particles in the mixture.

The metal fine particles having an average particle diameter outside the above range include a protective layer. The protective layer of the metal fine particles used has a ratio of 100 : 0 between the C5-7 monoalkylamine and an amine different from these amines. The protective layer of the metal fine particles having an average particle diameter outside the above range may be formed of a substance that can be used as a component of the protective layer of the metal fine particles A described later.

In the present invention, the average particle diameter of the metal fine particles A is an average value of the length of long sides of 30 or more particles included in an image observed with a scanning electron microscope. When metal fine particles having a single average particle diameter are used as the metal fine particles A of the present invention, the average particle diameter can be determined to be an average value of the length of long sides of any 30 or more particles included in an image observed with a scanning electron microscope. When types of metal fine particles having different average particle diameters are used in combination, the average particle diameter can be determined on the basis of an average value of the length of long sides of 30 or more particles of each of the types of metal fine particles included in an image observed with a scanning electron microscope and a mixing ratio between the types of metal fine particles.

More specifically, for example, when two types of metal fine particles having different average particle diameters are used in combination, the average particle diameter can be derived by the following equation (A), assuming that the true density of the metal fine particles is constant. 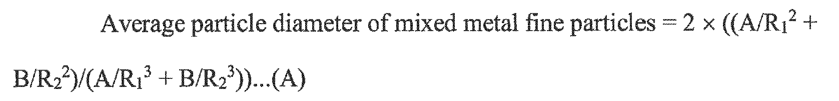 Average particle diameter of mixed metal fine particles = 2 × ((A/R12 + B/R22)/(A/R13 + B/R23)) (A) [In the equation, A : B represents a ratio between metal fine particles having a small average particle diameter and metal fine particles having a large average particle diameter, R₁ represents the radius of the metal fine particles having a small average particle diameter, and R₂ represents the radius of the metal fine particles having a large average particle diameter.]

Further, for example, when three types of metal fine particles having different average particle diameters are used in combination, the average particle diameter can be derived by the following equation (B), assuming that the true density of the metal fine particles is constant. 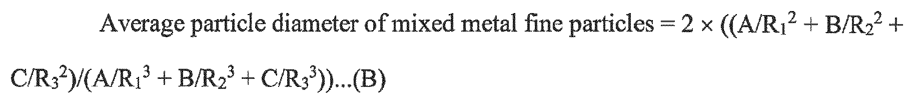 Average particle diameter of mixed metal fine particles = 2 × ((A/R12 + B/R22 + C/R32)/(A/R13 + B/R23 + C/R33)) (B) [In the equation, A : B : C represents a ratio among metal fine particles having a small average particle diameter, metal fine particles having a medium average particle diameter, and metal fine particles having a large average particle diameter, R₁ represents the radius of the metal fine particles having a small average particle diameter, R₂ represents the radius of the metal fine particles having a medium average particle diameter, and R₃ represents the radius of the metal fine particles having a large average particle diameter.]

In the electroconductive adhesive according to the present invention, the content of the metal fine particles is not particularly limited but is, for example, preferably 80% by mass or more, more preferably about 85% by mass to about 95% by mass.

Examples of the type of metal for the metal fine particles A of the present invention include gold, silver, copper, platinum, palladium, nickel, and aluminum. Among these metals, gold, silver, and platinum are preferable in terms of electroconductivity, silver, copper, and nickel are preferable in terms of costs and low-temperature sinterability, and silver is particularly preferable.

The metal fine particles A of the present invention include the protective layer on the surface layer of particles (metal particles) formed of metal. A material for forming the protective layer is not particularly limited as long as it is capable of forming the surface layer of the metal particles and functioning as the protective layer (for example, a layer that suppresses mutual aggregation of the metal fine particles A). The material is, for example, preferably a fatty acid, an amine, or a hydroxy fatty acid, from a viewpoint of effectively increasing the mechanical strength of a sintered object of the electroconductive adhesive. The protective layer may be formed of one material or two or more materials.

### Fatty- acid

The fatty acid in the protective layer is not particularly limited but is, for example, preferably a fatty acid having an alkyl group with 3 or more and 18 or less carbon atoms, more preferably a fatty acid having an alkyl group with 4 or more and 18 or less carbon atoms. Preferable specific examples of the fatty acid include acetic acid, propionic acid, butyric acid, valeric acid, caproic acid, caprylic acid, 2-ethylhexanoic acid, capric acid, lauric acid, myristic acid, palmitic acid, stearic acid, oleic acid, linoleic acid, and α-linolenic acid. Specific examples of the fatty acid also include cyclic alkyl carboxylic acids such as cyclohexanecarboxylic acid. Among these fatty acids, preferable are caproic acid, 2-ethylhexylic acid, oleic acid, linoleic acid, and α-linolenic acid, from a viewpoint of effectively increasing the mechanical strength of a sintered object of the electroconductive adhesive. The fatty acid in the protective layer may be formed of one fatty acid or two or more fatty acids.

### Amine

The amine contained in the protective layer of the metal fine particles A is characterized by including the C5-7 monoalkylamine. As the amine contained in the protective layer, any amine can be used without particularly problems as long as it includes at least one of the C5-7 monoalkylamine (particularly, a monoalkylamine with 6 carbon atoms is preferable). The amine in the protective layer is formed of only at least one of the C5-7 monoalkylamine.

The protective layer has a ratio of 100 : 0 between the C5-7 monoalkylamine and an amine different from these amines. With the protective layer having said ratio, it is possible to obtain a sintered object excellent in mechanical strength (shear strength) when the electroconductive adhesive is sintered.

The ratio of amines contained in the protective layer can be calculated on the basis of gas chromatography. Specifically, 1 g of metal fine particles is dispersed in 4 g of methanol, then a few drops of concentrated hydrochloric acid are added to the dispersion and well stirred to make amines in the protective layer free in methanol, and the thus prepared solution is neutralized with sodium hydroxide and introduced into gas chromatography. The ratio of the amines can be quantitated by the peak areas of the amines obtained by gas chromatography. The amounts of the amines contained in the protective layer are represented by content (%) based on values of the peak areas obtained according to the measuring method described above.

Examples of the monoalkylamine with 5 to 7 carbon atoms include n-amylamine, n-hexylamine, n-heptylamine, cyclohexylamine, and cycloheptylamine. Among these amines, n-amylamine, n-hexylamine, and n-heptylamine are preferable, and n-hexylamine is particularly preferable. The C5-7 monoalkylamine in the protective layer may be formed of one monoalkylamine or two or more monoalkylamines.

In the electroconductive adhesive according to the present invention, the amine contained in the protective layer of the metal fine particles A is separated from a surface of the metal fine particles A during sintering of the electroconductive adhesive, not to substantially affect the electroconductivity of a sintered object obtained.

Specific examples of the amine different from the C5-7 monoalkylamine include a primary amine, a secondary amine, a tertiary amine, and a diamine compound that is one compound having two amino groups. These amines, however, do not form part of the present invention.

Examples of the primary amine include amines having a straight or branched hydrocarbon group, such as ethylamine, n-propylamine, isopropylamine, n-butylamine, isobutylamine, sec-butylamine, tert-butylamine, n-octylamine, 2-octylamine, tertoctylamine, 2-ethylhexylamine, n-nonylamine, n-aminodecane, n-aminoundecane, n-dodecylamine, n-tridecylamine, 2-tridecylamine, n-tetradecylamine, n-pentadecylamine, n-hexadecylamine, n-heptadecylamine, n-octadecylamine, n-oleylamine, 3-methoxypropylamine, 3-ethoxypropylamine, 3-propoxypropylamine, 3-isopropoxypropylamine, 3-butoxypropylamine, N-ethyl-1,3-diaminopropane, N,N-diisopropylethylamine, N,N-dimethyl-1,3-diaminopropane, N,N-dibutyl-1,3-aminopropane, N,N-diisobutyl-1,3-diaminopropane, and N-lauryl diaminopropane.

Examples of the primary amine also include alicyclic amines such as cyclopropylamine, cyclobutylamine, and cyclooctylamine, and aromatic amines such as aniline.

Examples of the primary amine also include ether amines such as 3-isopropoxypropylamine and isobutoxypropylamine.

Examples of the secondary amine include dialkylmonoamines such as N,N-dipropylamine, N,N-dibutylamine, N,N-dipentylamine, N,N-dihexylamine, N,N-dipeptylamine, N,N-dioctylamine, N,N-dinonylamine, N,N-didecylamine, N,N-diundecylamine, N,N-didodecylamine, N,N-distearylamine, N-methyl-N-propylamine, N-ethyl-N-propylamine, and N-propyl-N-butylamine, and cyclic amines such as piperidine.

Examples of the tertiary amine include triethylamine, tributylamine, trihexylamine, dimethyloctylamine, dimethyldecylamine, dimethyllaurylamine, dimethylmyristylamine, dimethylpalmitylamine, dimethylstearylamine, and dilaurylmonomethylamine.

Examples of the diamine compound include ethylenediamine, N,N-dimethylethylenediamine, N,N'-dimethylethylenediamine, N,N-diethylethylenediamine, N,N'-diethylethylenediamine, 1,3-propanediamine, 2,2-dimethyl-1,3-propanediamine, N,N-dimethyl-1,3-propanediamine, N,N'-dimethyl-1,3-propanediamine, N,N-diethyl-1,3-propanediamine, N,N'-diethyl-1,3-propanediamine, 1,4-butanediamine, N,N-dimethyl-1,4-butanediamine, N,N'-dimethyl-1,4-butanediamine, N,N-diethyl-1,4-butanediamine, N,N'-diethyl-1,4-butanediamine, 1,5-pentanediamine, 1,5-diamino-2-methylpentane, 1,6-hexanediamine, N,N-dimethyl-1,6-hexanediamine, N,N'-dimethyl-1,6-hexanediamine, 1,7-heptanediamine, and 1,8-octanediamine.

When the protective layer contains an amine and a fatty acid in combination, the molar ratio (amine : fatty acid) between the amine and the fatty acid is preferably in a range of about 90 : 10 to about 99.9 : 0.1, more preferably in a range of about 95 : 5 to about 99.5 : 0.5.

The protective layer of the metal fine particles A in the present invention may further contain a hydroxy fatty acid. As the hydroxy fatty acid that can be contained in the protective layer, as the hydroxy fatty acid, it is possible to use a compound with 3 to 24 carbon atoms and at least one hydroxy group (for example, one hydroxy group). Examples of the hydroxy fatty acid include 2-hydroxydecanoic acid, 2-hydroxydodecanoic acid, 2-hydroxytetradecanoic acid, 2-hydroxyhexadecanoic acid, 2-hydroxyoctadecanoic acid, 2-hydroxyeicosanoic acid, 2-hydroxydocosanoic acid, 2-hydroxytricosanoic acid, 2-hydroxytetracosanoic acid, 3-hydroxyhexanoic acid, 3-hydroxyoctanoic acid, 3-hydroxynonanoic acid, 3-hydroxydecanoic acid, 3-hydroxyundecanoic acid, 3-hydroxydodecanoic acid, 3-hydroxytridecanoic acid, 3-hydroxytetradecanoic acid, 3-hydroxyhexadecanoic acid, 3-hydroxyheptadecanoic acid, 3-hydroxyoctadecanoic acid, ω-hydroxy-2-decenoic acid, ω-hydroxypentadecanoic acid, ω-hydroxyheptadecanoic acid, ω-hydroxyeicosanoic acid, ω-hydroxydocosanoic acid, 6-hydroxyoctadecanoic acid, ricinoleic acid, 12-hydroxystearic acid, and [R-(E)]-12-hydroxy-9-octadecenoic acid. Among these hydroxy fatty acids, preferable is a hydroxy fatty acid with 4 to 18 carbon atoms and one hydroxy group at a position (particularly, the 12-position) other than the ω-position, and more preferable are ricinoleic acid and 12-hydroxystearic acid. The hydroxy fatty acid contained in the second protective layer may be one hydroxy fatty acid or two or more hydroxy fatty acids.

When containing a hydroxy fatty acid, the protective layer may have a content of the hydroxy fatty acid in a range of 0.1 to 10 mol, preferably in a range of 0.2 to 5 mol, relative to 1 mol of the amine.

The proportion (% by mass) of the protective layer in the metal fine particles A is not particularly limited but is preferably about 0.1% by mass to about 10% by mass, more preferably about 0.2% by mass to about 8% by mass, further preferably about 0.2% by mass to about 5% by mass, from a viewpoint of effectively increasing the mechanical strength of a sintered object of the electroconductive adhesive while protecting a surface of the metal fine particles A.

As the metal fine particles A used in the present invention, commercially available metal fine particles may be purchased and used as long as the particles have features described above, or metal fine particles may be used that have been manufactured by a normally employed method (for example, Japanese Patent Laid-open Publication No. 2015-40319) of manufacturing metal fine particles (for example, silver fine particles). The method of manufacturing metal fine particles is described later in detail.

### Solvent

The electroconductive adhesive according to the present invention preferably further contains a solvent in addition to the metal fine particles A. The electroconductive adhesive containing a solvent increases its flowability, so that it becomes easy to dispose the electroconductive adhesive according to the present invention at a desired place.

The solvent is not particularly limited as long as it allows the metal fine particles A to be dispersed therein but preferably includes a polar organic solvent. Examples of the polar organic solvent include ketones such as acetone, acetylacetone, and methyl ethyl ketone; ethers such as diethyl ether, dipropyl ether, dibutyl ether, tetrahydrofuran, and 1,4-dioxane; diols such as 1,2-propanediol, 1,2-butanediol, 1,3-butanediol, 1,4-butanediol, 2,3-butanediol, 1,2-hexanediol, 1,6-hexanediol, 1,2-pentanediol, 1,5-pentanediol, 2-methyl-2,4-pentanediol, 3-methyl-1,5-pentanediol, 1,2-octanediol, 1,8-octanediol, and 2-ethyl-1,3-hexanediol; glycerol; alcohols such as a straight or branched alcohol with 1 to 5 carbon atoms, cyclohexanol, 3-methoxy-3-methyl-1-butanol, and 3-methoxy-1-butanol; fatty acid esters such as ethyl acetate, butyl acetate, ethyl butyrate, and ethyl formate; glycols or glycol ethers such as polyethylene glycol, triethylene glycol monomethyl ether, tetraethylene glycol monomethyl ether, ethylene glycol monoethyl ether, diethylene glycol monoethyl ether, diethylene glycol dimethyl ether, triethylene glycol dimethyl ether, tetraethylene glycol dimethyl ether, 3-methoxybutyl acetate, ethylene glycol monobutyl ether, ethylene glycol monobutyl ether acetate, ethylene glycol monohexyl ether, ethylene glycol monooctyl ether, ethylene glycol mono-2-ethylhexyl ether, ethylene glycol monobenzyl ether, diethylene glycol monomethyl ether, diethylene glycol monomethyl ether acetate, diethylene glycol monoethyl ether, diethylene glycol monoethyl ether acetate, diethylene glycol monobutyl ether, diethylene glycol monobutyl ether acetate, polypropylene glycol, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, tripropylene glycol monomethyl ether, tripropylene glycol monoethyl ether, tripropylene glycol monopropyl ether, and tripropylene glycol monobutyl ether; N,N-dimethylformamide; dimethyl sulfoxide; terpenes such as terpineol; acetonitrile; γ-butyrolactone; 2-pyrrolidone; N-methylpyrrolidone; and N-(2-aminoethyl)piperazine. Among these polar organic solvents, preferable are a straight or branched alcohol with 3 to 5 carbon atoms, 3-methoxy-3-methyl-1-butanol, 3-methoxy-1-butanol, diethylene glycol monobutyl ether, diethylene glycol monobutyl ether acetate, and terpineol, from a viewpoint of further effectively increasing the mechanical strength of a sintered object of the electroconductive adhesive.

The solvent may include a non-polar or hydrophobic solvent in addition to the polar organic solvent. Examples of the non-polar organic solvent include straight, branched, or cyclic saturated hydrocarbons such as hexane, heptane, octane, nonane, decane, 2-ethylhexane, and cyclohexane; alcohols such as a straight or branched alcohol with 6 or more carbon atoms; aromatic compounds such as benzene, toluene, and benzonitrile; halogenated hydrocarbons such as dichloromethane, chloroform, and dichloroethane; methyl-n-amyl ketone; methyl ethyl ketone oxime; and triacetin. Among these non-polar organic solvents, preferable are a saturated hydrocarbon and straight or branched alcohols with 6 or more carbon atoms, and more preferable are hexane, octane, decane, octanol, decanol, and dodecanol. The solvent can be used that is formed of one solvent alone or two or more solvents in mixture.

When the solvent includes both a polar organic solvent and a non-polar organic solvent, the proportion of the polar organic solvent is preferably 5% by volume or more, more preferably 10% by volume or more, further preferably 15% by volume or more of the total amount of the solvent. It is also possible to set the proportion to 60% by volume or less, 55% by volume or less, 50% by volume or less. The solvent can be formed of only the polar organic solvent. The electroconductive adhesive according to the present invention has good dispersibility of the metal fine particles A also when thus containing a large amount of polar organic solvent.

In the electroconductive adhesive according to the present invention, the ratio of the solvent is not particularly limited but is preferably 20% by mass or less, more preferably about 5% by mass to about 15% by mass.

The electroconductive adhesive according to the present invention can be manufactured by a method including a step of mixing metal fine particles A that include a protective layer containing an amine and have an average particle diameter of 30 nm to 300 nm (more specifically, mixing metal fine particles A with a solvent). In a method of manufacturing an electroconductive adhesive according to the present invention, used are the metal fine particles A, the amine including a monoalkylamine with 5 to 7 carbon atoms, and the protective layer having a ratio of 100 : 0 between the monoalkylamine with 5 to 7 carbon atoms and an amine different from these amines.

The method of manufacturing an electroconductive adhesive according to the present invention may further include a step of arranging metal fine particles that include a protective layer containing an amine and have an average particle diameter of 30 nm to 300 nm, and substituting the amine contained in the protective layer of the metal fine particles by the monoalkylamine with 5 to 7 carbon atoms and thus adjusting the ratio to 100 : 0 between the monoalkylamine with 5 to 7 carbon atoms and an amine different from these amines to prepare the metal fine particles A. As the method of preparing the metal fine particles A by substituting the amine, it is possible to employ the following method, for example.

### 2. Method of manufacturing metal fine particles A

Described below is one example of the method of manufacturing metal fine particles A (for example, silver fine particles) used in the present invention.

First, a composition for manufacturing the metal fine particles A (silver fine particle preparation composition) is arranged. Specifically, arranged are a silver compound to be a raw material for silver fine particles (preferably, for example, silver nitrate or silver oxalate), a component for forming a protective layer (for example, the fatty acid, the amine, and the hydroxy fatty acid that are described above), and an organic solvent. Next, these components are mixed to give the silver fine particle preparation composition. The proportion of each of the components in the composition may be appropriately adjusted so as to give the constitution of the metal fine particles A described above. For example, the content of silver oxalate in the composition is preferably set to about 20 to 70% by mass of the total amount of the composition. When the protective layer contains a fatty acid, the content of the fatty acid is preferably set to about 0.1% by mass to about 20% by mass of the total amount of the composition. The content of an amine in the protective layer is preferably set to about 5% by mass to about 55% by mass of the total amount of the composition. When the protective layer contains a hydroxy fatty acid, the content of the hydroxy fatty acid is preferably set to about 0.1% by mass to about 15% by mass of the total amount of the composition.

The amine may be used by adjusting the ratio between a C5-7 monoalkylamine and an amine different from these amines to the above range. Alternatively, it is also possible to synthesize silver fine particles using a silver fine particle preparation composition that has been adjusted such that the ratio in a protective layer becomes outside the above range, and adjust the ratio to within the above range by the following method (substitution of an amine).

Means for mixing the components is not particularly limited, and it is possible to mix the components with widely used equipment such as a mechanical stirrer, a magnetic stirrer, a vortex mixer, a planetary mill, a ball mill, a three roll mill, a line mixer, a planetary mixer, or a dissolver. In order to avoid the silver fine particles from starting a thermal decomposition reaction by a rise in temperature of the composition due to an influence of, for example, heat of dissolution or heat of friction during mixing, it is preferable to mix the components while keeping the temperature of the composition at, for example, 60°C or lower, particularly 40°C or lower.

Next, the silver fine particle preparation composition is reacted in a reaction vessel, usually reacted by heating to cause a thermal decomposition reaction of the silver compound and thus generate silver fine particles. For the reaction, the composition may be introduced into the reaction vessel that has been heated in advance or may be heated after introduced into the reaction vessel.

The reaction temperature may be any temperature that allows progress of the thermal decomposition reaction and generation of the silver fine particles. The reaction temperature is, for example, about 50 to 250°C. The reaction time may be appropriately selected according to the size of a desired average particle diameter and the constitution of the silver fine particle preparation composition corresponding to the size of the desired average particle diameter. The reaction time is, for example, 1 minute to 100 hours.

The silver fine particles generated by the thermal decomposition reaction are obtained as a mixture containing an unreacted raw material, so that it is preferable to purify the silver fine particles. Examples of a purifying method include a solid-liquid separation method and a precipitation method of using the difference in specific gravity between the silver fine particles and the unreacted raw material such as the organic solvent. Examples of the solid-liquid separation method include filter filtration, centrifugation, cyclone-type separation, and decantation. For easy handling of the mixture during purification, the mixture containing the silver fines particles may be diluted with a low-boiling-point solvent such as acetone or methanol to adjust the viscosity of the mixture.

It is possible to adjust the average particle diameter of the obtained silver fine particles by adjusting the constitution of the silver fine particle manufacturing composition and the reaction conditions.

### 3. Method of adjusting ratio between amines in protective layer (substitution)

As regards the metal fine particles described in Section "2. Method of manufacturing metal fine particles A" and obtained by adjusting the ratio between the amines (the ratio between the C5-7 monoalkylamine and an amine different from these amines) in the protective layer to outside the above range, described is a method of adjusting the ratio to within the above range (substitution).

It is possible to adjust the ratio between the amines in the protective layer to within the above range (substitution) by dispersing in a solvent the metal fine particles having a ratio outside the above range between the C5-7 monoalkylamine and an amine different from these amines that are included in the protective layer as the amine, adding at least one of the C5-7 monoalkylamine in an amount ranging from 0.1 to 5 times the mass of the metal fine particles, and subjecting the dispersion to a step of stirring at room temperature to 80°C for 1 minute to 24 hours. Alternatively, it is also possible to adjust the ratio between the C5-7 monoalkylamine and an amine different from these amines in the protective layer of the metal fine particles to a desired ratio by adding the metal fine particles to a solvent having the ratio between the amines adjusted to a specific ration in advance.

As the solvent for dispersing the metal fine particles, a solvent may be used that can be used for synthesis of the metal fine particles or a solvent may be used that can be used for the electroconductive adhesive. The metal fine particles having the ratio between the amines in the protective layer adjusted to within the above range (substitution) can be recovered by the solid-liquid separation method described in Section "2. Method of manufacturing metal fine particles A." The method of adjusting the ratio between the amines in the protective layer (substitution) enables, also for the metal fine particles having an average particle diameter outside the above range, the adjustment of the ratio between the C5-7 monoalkylamine and an amine different from these amines in the protective layer to a desired ratio.

### 4. Sintered object of electroconductive adhesive

A sintered object of the electroconductive adhesive according to the present invention can be obtained by sintering the electroconductive adhesive according to the present invention described above in detail in Section "1. Electroconductive adhesive." In the sintered object of the electroconductive adhesive according to the present invention, most of the components forming the protective layer of the electroconductive adhesive are separated by high heat during sintering, so that the sintered object is substantially formed of metal.

The sintering temperature is not particularly limited but is, for example, preferably about 150°C to about 200°C, more preferably about 150°C to about 185°C, from a viewpoint of effectively increasing the mechanical strength while allowing the obtained sintered object to exhibit high electroconductivity and high adhesion force. The sintering time is, for example, preferably about 0.4 hours to about 2.0 hours, more preferably about 0.5 hours to about 1.2 hours from the same viewpoint. The sintering can be performed in an atmosphere of, for example, air or an inert gas (nitrogen gas or argon gas). Sintering means is not particularly limited, and examples of the means include an oven, a hot air drying furnace, an infrared drying furnace, laser irradiation, flash lamp irradiation, and a microwave.

### 5. Circuit or apparatus

A circuit or an apparatus according to the present invention includes a part that bonds between members and is the sintered object according to the present invention. That is, the circuit or the apparatus according to the present invention is one obtained by disposing the electroconductive adhesive according to the present invention described above in detail in Section "1. Electroconductive adhesive" between members of a circuit or an apparatus and sintering the electroconductive adhesive to bond the members.

As described above, the sintered object according to the present invention is effectively increased in mechanical strength while allowed to exhibit high electroconductivity and high adhesion force, so that the circuit or the apparatus including the sintered object is excellent in electroconductivity and adhesiveness between the members and is also excellent in mechanical strength.

### EXAMPLES

The present invention is more specifically described by way of the following examples. The present invention, however, is not limited to these examples.

The detail of the components used in the examples and comparative examples is as follows.
- Silver oxalate ((COOAg)₂) synthesized by a method described in Patent Document 1 (Patent No. 5574761)
- Oleic acid (manufactured by Wako Pure Chemical Industries, Ltd.)
- N,N-Dimethyl-1,3-diaminopropane (manufactured by Wako Pure Chemical Industries, Ltd.)
- N,N-Diethyl-1,3-diaminopropane (manufactured by Wako Pure Chemical Industries, Ltd.)
- n-Hexylamine (6 carbon atoms, manufactured by Wako Pure Chemical Industries, Ltd.)
- n-Propylamine (3 carbon atoms, manufactured by Wako Pure Chemical Industries, Ltd.)
- n-Butylamine (4 carbon atoms, manufactured by Wako Pure Chemical Industries, Ltd.)
- 3-Methoxypropylamine (4 carbon atoms, manufactured by Wako Pure Chemical Industries, Ltd.)
- 2-(2-Ethylhexyloxy)ethanol (manufactured by Wako Pure Chemical Industries, Ltd.)
- Butanol (manufactured by Wako Pure Chemical Industries, Ltd.)
- Pentanol(manufactured by Wako Pure Chemical Industries, Ltd.)

In the following examples and comparative examples, an amine(s) in a protective layer of synthesized silver fine particles is measured by the following method.

### (Method of measuring ratio of amine(s) contained in protective layer of silver fine particles)

Methanol in an amount of 4 g was added to 1 g of silver fine particles and the mixture was stirred for 1 minute. Subsequently, 100 mg of concentrated hydrochloric acid was added to the mixture while the mixture was stirred, and the stirring was continued for another 10 minutes to free a protective layer. While the stirring was further continued, 150 mg of a 48% aqueous solution of sodium hydroxide was added to the mixture to give a solid-liquid mixture having a pH of more than 7. The solid-liquid mixture was filtrated to give a methanol solution containing an extracted amine(s) that had been contained in the protective layer, and the methanol solution was used as a sample for gas chromatography. The sample was analyzed by gas chromatography (GC-2010 manufactured by SHIMADZU CORPORATION, column: Rtx-5 Amine manufactured by Restek Corporation), and the ratio (GC%) of the amine(s) contained in the protective layer was quantitated by the obtained ratio of a peak area(s) of the amine(s). Tables 1 to 3 show the results.

In Tables 1 to 3, HA represents n-hexylamine, MP represents methoxypropylamine, DA represents N,N-diethyl-1,3-diaminopropane or N,N-dimethyl-1,3-diaminopropane, BuNH₂ represents n-butylamine, and PrNH₂ represents n-propylamine.

In the following examples and comparative examples, the mechanical strength and cracks and chips on a coating film were evaluated as follows. Tables 1 to 3 show the results.

### (Evaluation of mechanical strength)

The shear strength of a coating film obtained in each of the examples and comparative examples was measured by performing a die shear test with use of a bond tester (SS30-WD manufactured by SEISHIN TRADING CO., LTD.).

### Evaluation of cracks and chips on coating film

A surface of a coating film obtained in each of the examples and comparative examples was observed by visual inspection and evaluated for presence or absence of cracks and chips on the coating film.

### <Synthesis Example 1>_Synthesis example of metal fine particles having average particle diameter of 200 nm

Oleic acid (0.1 g), N,N-diethyl-1,3-diaminopropane (3.25 g), and pentanol (4.0 g) were charged into 50-mL glass-made centrifuge tubes each having a magnetic stirrer placed therein, the mixture was stirred for about 1 minute, and then, silver oxalate (4.0 g) was charged into each of the centrifuge tubes and stirred for about 10 minutes to give a silver fine particle preparation composition. Subsequently, these glass-made centrifuge tubes were set upright on a hot stirrer equipped with an aluminum block (HHE-19G-U manufactured by KOIKE PRECISION INSTRUMENTS), and the composition was stirred at 40°C for 30 minutes and further stirred at 90°C for 30 minutes. After the composition was allowed to cool, the magnetic stirrer was taken out, and 15 g of methanol was added to the composition and stirred with a vortex mixer. Then, the composition was subjected to centrifugal operation for 1 minute at 3000 rpm (about 1600 × G) by a centrifugal machine (CF7D2 manufactured by Hitachi Koki Co., Ltd.) and the centrifuge tube was inclined to remove a supernatant. The step of addition of 15 g of methanol, stirring, centrifugation, and removal of a supernatant was repeated two times, and silver fine particles 1 manufactured were recovered. The silver fine particles 1 obtained in Synthesis Example 1 were observed with a scanning electron microscope (S-4500 manufactured by Hitachi High-Technologies Corporation) and measurement was performed for the length of long sides of any 30 particles included in an image to determine an average value. The average particle diameter was 200 nm.

### Method of adjusting ratio of amine contained in protective layer of silver fine particles 1 (substitution)

To a dispersion (methanol solution) containing the silver fine particles 1 obtained in Synthesis Example 1, each of n-hexylamine (used for preparing silver fine particles 1A) and methoxypropylamine (used for preparing silver fine particles 1B) was added in an amount of 3 times the mass of the silver fine particles 1 and stirred at room temperature for 4 hours to prepare a composition. After the stirring, the magnetic stirrer was taken out, and 15 g of methanol was added to each of the compositions and stirred with the vortex mixer. Then, the composition was subjected to centrifugal operation for 1 minute at 3000 rpm (about 1600 × G) by the centrifugal machine (CF7D2 manufactured by Hitachi Koki Co., Ltd.) and the centrifuge tube was inclined to remove a supernatant. The step of addition of 15 g of methanol, stirring, centrifugation, and removal of a supernatant was repeated two times to recover the silver fine particles 1A and 1B each having the ratio between the amines in the protective layer adjusted (substitution). The average particle diameter did not change.

### (Example 1 and Reference Example 2 (not in accordance with the present invention))

In Example 1 and Reference Example 2, the silver fine particles 1A and 1B were used, respectively. Terpineol in an amount corresponding to 10% of the total mass was added to the silver fine particles to give a dispersion. This dispersion was mixed using MAZERUSTAR manufactured by KURABO INDUSTRIES LTD. with a two-time stirring priority mode, to prepare an electroconductive adhesive.

Next, a substrate was arranged that included a copper plate having nonelectrolytic silver plating (0.5 µm) performed thereon, the electroconductive adhesive was uniformly applied onto the substrate to form a coating film such that the thickness of the coating film became 50 µm, and on the electroconductive adhesive was placed a silicon wafer (size 2 mm × 2 mm) having a rear surface (surface in contact with the electroconductive adhesive) thereof gold-plated or treated by gold sputtering. The layered product was heated by a drier (circulation type) at a predetermined temperature (150°C) for 60 minutes to give a coating film that is the electroconductive adhesive sintered.

### <Synthesis Example 2> Synthesis example of metal fine particles having average particle diameter of 75 nm

Oleic acid (0.1 g), N,N-diethyl-1,3-diaminopropane (3.25 g), and butanol (6.0 g) were charged into 50-mL glass-made centrifuge tubes each having a magnetic stirrer placed therein, the mixture was stirred for about 1 minute, and then, silver oxalate (4.0 g) was charged into each of the centrifuge tubes and stirred for about 10 minutes to give a silver fine particle preparation composition. Subsequently, these glass-made centrifuge tubes were set upright on a hot stirrer equipped with an aluminum block (HHE-19G-U manufactured by KOIKE PRECISION INSTRUMENTS), and the composition was stirred at 40°C for 30 minutes and further stirred at 90°C for 30 minutes. After the composition was allowed to cool, the magnetic stirrer was taken out, and 15 g of methanol was added to the composition and stirred with a vortex mixer. Then, the composition was subjected to centrifugal operation for 1 minute at 3000 rpm (about 1600 × G) by a centrifugal machine (CF7D2 manufactured by Hitachi Koki Co., Ltd.) and the centrifuge tube was inclined to remove a supernatant. The step of addition of 15 g of methanol, stirring, centrifugation, and removal of a supernatant was repeated two times, and silver fine particles 2 manufactured were recovered. The silver fine particles 2 obtained in Synthesis Example 2 were observed with the scanning electron microscope (S-4500 manufactured by Hitachi High-Technologies Corporation) and measurement was performed for the length of long sides of any 30 particles included in an image to determine an average value. The average particle diameter was 75 nm. The silver fine particles 2 obtained in Synthesis Example 2 were used in the examples as silver fine particles 2C.

### Method of adjusting ratio of amine contained in protective layer of silver fine particles 2 (substitution)

To a dispersion (methanol solution) containing the silver fine particles 2 obtained in Synthesis Example 2, each of n-hexylamine (used for preparing silver fine particles 2A), methoxypropylamine (used for preparing silver fine particles 2B), n-butylamine (used for preparing silver fine particles 2D), and n-propylamine (used for preparing silver fine particles 2E) was added in an amount of 3 times the mass of the silver fine particles 2 and stirred at room temperature for 4 hours to prepare a composition. After the stirring, the magnetic stirrer was taken out, and 15 g of methanol was added to each of the compositions and stirred with the vortex mixer. Then, the composition was subjected to centrifugal operation for 1 minute at 3000 rpm (about 1600 × G) by the centrifugal machine (CF7D2 manufactured by Hitachi Koki Co., Ltd.) and the centrifuge tube was inclined to remove a supernatant. The step of addition of 15 g of methanol, stirring, centrifugation, and removal of a supernatant was repeated two times to recover the silver fine particles 2A to 2E each having the ratio between the amines in the protective layer adjusted (substitution). The average particle diameter did not change.

### (Reference Examples 3 and 4 (not in accordance with the present invention) and Comparative Examples 1 to 3)

Terpineol in an amount corresponding to 10% of the total mass was added to each of the silver fine particles 2A to 2E obtained above to give a dispersion. The silver fine particles 2A was used in Reference Example 3, the silver fine particles 2B in Reference Example 4, the silver fine particles 2C in Comparative Example 1, the silver fine particles 2D in Comparative Example 2, and the silver fine particles 2E in Comparative Example 3. Each of these dispersions was mixed using MAZERUSTAR manufactured by KURABO INDUSTRIES LTD. with a two-time stirring priority mode, to prepare an electroconductive adhesive.

Next, a substrate was arranged that included a copper plate having nonelectrolytic silver plating (0.5 µm) performed thereon, the electroconductive adhesive was uniformly applied onto the substrate to form a coating film such that the thickness of the coating film became 50 µm, and on the electroconductive adhesive was placed a silicon wafer (size 2 mm × 2 mm) having a rear surface (surface in contact with the electroconductive adhesive) thereof gold-plated or treated by gold sputtering. The layered product was heated by a drier (circulation type) at a predetermined temperature (150°C) for 60 minutes to give a coating film that is the electroconductive adhesive sintered.

### <Synthesis Example 3> Synthesis example of metal fine particles having average particle diameter of 20 nm

Oleic acid (0.06 g), hexylamine (1.4 g), N,N-dimethyl-1,3-diaminopropane (0.3 g), butylamine (0.6 g), and 2-(2-ethylhexyloxy)ethanol (4.0 g) were charged into 50-mL glass-made centrifuge tubes each having a magnetic stirrer placed therein, the mixture was stirred for about 1 minute, and then, silver oxalate (4.0 g) was charged into each of the centrifuge tubes and stirred for about 10 minutes to give a silver fine particle preparation composition. Subsequently, these glass-made centrifuge tubes were set upright on a hot stirrer equipped with an aluminum block (HHE-19G-U manufactured by KOIKE PRECISION INSTRUMENTS), and the composition was stirred at 40°C for 30 minutes and further stirred at 90°C for 30 minutes. After the composition was allowed to cool, the magnetic stirrer was taken out, and 15 g of methanol was added to the composition and stirred with a vortex mixer. Then, the composition was subjected to centrifugal operation for 1 minute at 3000 rpm (about 1600 × G) by a centrifugal machine (CF7D2 manufactured by Hitachi Koki Co., Ltd.) and the centrifuge tube was inclined to remove a supernatant. The step of addition of 15 g of methanol, stirring, centrifugation, and removal of a supernatant was repeated two times, and silver fine particles 6 manufactured were recovered. The silver fine particles 3 obtained in Synthesis Example 3 were observed with the scanning electron microscope (S-4500 manufactured by Hitachi High-Technologies Corporation) and measurement was performed for the length of long sides of any 30 particles included in an image to determine an average value. The average particle diameter was 20 nm.

### Method of adjusting ratio of amines contained in protective layer of silver fine particles 3 (substitution)

n-Hexylamine was added to a dispersion (methanol solution) containing the silver fine particles 3 obtained in Synthesis Example 3 in an amount of 3 times the mass of the silver fine particles and stirred at room temperature for 4 hours to prepare a composition. After the stirring, the magnetic stirrer was taken out, and 15 g of methanol was added to each of the compositions and stirred with the vortex mixer. Then, the composition was subjected to centrifugal operation for 1 minute at 3000 rpm (about 1600 × G) by the centrifugal machine (CF7D2 manufactured by Hitachi Koki Co., Ltd.) and the centrifuge tube was inclined to remove a supernatant. The step of addition of 15 g of methanol, stirring, centrifugation, and removal of a supernatant was repeated two times to recover silver fine particles 3A having the ratio between the amines contained in the protective layer adjusted (substitution). The average particle diameter did not change.

### (Comparative Example 4)

Terpineol in an amount corresponding to 10% of the total mass was added to the silver fine particles 3A to give a dispersion. This dispersion was mixed using MAZERUSTAR manufactured by KURABO INDUSTRIES LTD. with a two-time stirring priority mode, to prepare an electroconductive adhesive.

Next, a substrate was arranged that included a copper plate having nonelectrolytic silver plating (0.5 µm) performed thereon, the electroconductive adhesive was uniformly applied onto the substrate to form a coating film such that the thickness of the coating film became 50 µm, and on the electroconductive adhesive was placed a silicon wafer (size 2 mm × 2 mm) having a rear surface (surface in contact with the electroconductive adhesive) thereof gold-plated or treated by gold sputtering. The layered product was heated by a drier (circulation type) at a predetermined temperature (150°C) for 60 minutes to give a coating film that is the electroconductive adhesive sintered.

**[Table 1]**

| Silver fine particles (amine in protective layer) | | | Example 1 | Example 2* | Example 3* | Example 4* | Comparative Example 1 | Comparative Example 2 | Comparative Example 3 | Comparative Example 4 |
|---|---|---|---|---|---|---|---|---|---|---|
| Mixing ratio (part by mass) | 1A | 200 nm (n-Hexylamine) | 100 | | | | | | | |
| | 1B | 200 nm (3-Methoxypropylamine) | | 100 | | | | | | |
| | 2A | 75 nm (n-Hexylamine) | | | 100 | | | | | |
| | 2B | 75 nm (3-Methoxypropylamine) | | | | 100 | | | | |
| | 2C | 75 nm (Diethyl diaminopropane) | | | | | 100 | | | |
| | 2D | 75 nm (n-Butylamine) | | | | | | 100 | | |
| | 2E | 75 nm (n-Propylamine) | | | | | | | 100 | |
| | 3A | 20 nm (n-Hexylamine) | | | | | | | | 100 |
| Average particle diameter (nm) | | | 200 | 200 | 75 | 75 | 75 | | | 20 |
| Ratio between amines (GC%) | | | HA | MP | HA:DA | MP:DA | DA | BuNH₂ | PrNH₂ | HA |
| | | | 100 | 100 | 99:1 | 98:2 | 100 | 100 | 100 | 100 |
| Cracks on coating film | | | None | None | None | None | None | None | None | Found |
| Shear strength [kgf] | | | 25.8 | 12.9 | 13.5 | 11.2 | 3.2 | 1.2 | 1.7 | 0.6 |

| | | | | | | | | | | |
|---|---|---|---|---|---|---|---|---|---|---|
| * not in accordance with the present invention | | | | | | | | | | |

As is clear from the results shown in Table 1, the electroconductive adhesive of Example 1 was high in shear strength of the coating film and had neither cracks nor chips on the coating film. In the electroconductive adhesive, the metal fine particles had an average particle diameter in a range of 30 nm to 300 nm, the amine in the protective layer included a monoalkylamine with 5 to 7 carbon atoms, and the ratio between the monoalkylamine with 5 to 7 carbon atoms and an amine different from these amines was 100 : 0. On the other hand, the electroconductive adhesives of Comparative Examples 1 to 3 were low in shear strength of the coating film. In the electroconductive adhesives, the protective layer contained, as the amine, N,N-diethyl-1,3-diaminopropane, n-butylamine, and n-propylamine at a ratio of 100% in Comparative Examples 1 to 3, respectively. The electroconductive adhesive of Comparative Example 4 where the metal fine particles had an average particle diameter of 20 nm was also low in shear strength of the coating film.

### (Examples 5, 7, and 8 and Reference Examples 6 and 9 to 11 (not in accordance with the present invention))

The silver fine particles 1A, 1B, 2A, 2B, and 2C obtained above were mixed at a ratio shown in Table 2, and terpineol in an amount corresponding to 10% of the total mass was added to give a dispersion. This dispersion was mixed using MAZERUSTAR manufactured by KURABO INDUSTRIES LTD. with a two-time stirring priority mode, to prepare an electroconductive adhesive. The average particle diameter after the mixing was obtained by the method described above.

Next, a substrate was arranged that included a copper plate having nonelectrolytic silver plating (0.5 µm) performed thereon, the electroconductive adhesive was uniformly applied onto the substrate to form a coating film such that the thickness of the coating film became 50 µm, and on the electroconductive adhesive was placed a silicon wafer (size 2 mm × 2 mm) having a rear surface (surface in contact with the electroconductive adhesive) thereof gold-plated or treated by gold sputtering. The layered product was heated by a drier (circulation type) at a predetermined temperature (150°C) for 60 minutes to give a coating film that is the electroconductive adhesive sintered.

**[Table 2]**

| Silver fine particles (amine in protective layer) | | | Example 5 | Example 6* | Example 7 | Example 8 | Example 9* | Example 10* | Example 11* |
|---|---|---|---|---|---|---|---|---|---|
| Mixing ratio (part by mass) | 1A | 200 nm (n-Hexylamine) | 50 | | 25 | 10 | | 50 | |
| | 1B | 200 nm (3-Methoxypropylamine) | | 50 | | | | | 50 |
| | 2A | 75 mn (n-Hexylamine) | 50 | 50 | 75 | 90 | 50 | | |
| | 2B | 75 nm (3-Methoxypropylamine) | | | | | | | |
| | 2C | 75 nm (Diethyl diaminopropane) | | | | | 50 | 50 | 50 |
| Average particle diameter (nm) | | | 81 | 81 | 77 | 76 | 75 | 81 | 81 |
| Ratio between amines (GC%) | | | HA | MP:HA | HA | HA | HA:DA | HA:DA | MP:DA |
| | | | 100 | 29:71 | 100 | 100 | 55:45 | 47:53 | 31:69 |
| Cracks on coating film | | | None | None | None | None | None | None | None |
| Shear strength [kgf] | | | 21.2 | 21.6 | 28.7 | 19.6 | 13.8 | 12.6 | 13.6 |

| | | | | | | | | | |
|---|---|---|---|---|---|---|---|---|---|
| * not in accordance with the present invention | | | | | | | | | |

As is clear from the results shown in Table 2, the electroconductive adhesives of Examples 5, 7, and 8 were high in shear strength of the coating film and had neither cracks nor chips on the coating film at a sintering temperature of 150°C, because while each of the electroconductive adhesives was obtained by mixing types of metal fine particles that had different average particle diameters and/or included the protective layers containing different amines, the mixed types of metal fine particles had an average particle diameter in a range of 30 nm to 300 nm, the amines in the protective layers included a monoalkylamine with 5 to 7 carbon atoms, and the ratio between the monoalkylamine with 5 to 7 carbon atoms and an amine different from these amines was 100 : 0.

### (Example 12 and Comparative Examples 5 and 6)

The silver fine particles 1A, 1B, 2A, 2B, 2C, and 3A obtained above were mixed at a ratio shown in Table 3, and terpineol in an amount corresponding to 10% of the total mass was added to give a dispersion. This dispersion was mixed using MAZERUSTAR manufactured by KURABO INDUSTRIES LTD. with a two-time stirring priority mode, to prepare an electroconductive adhesive. The average particle diameter after the mixing was obtained by the method described above.

Next, a substrate was arranged that included a copper plate having nonelectrolytic silver plating (0.5 µm) performed thereon, the electroconductive adhesive was uniformly applied onto the substrate to form a coating film such that the thickness of the coating film became 50 µm, and on the electroconductive adhesive was placed a silicon wafer (size 2 mm × 2 mm) having a rear surface (surface in contact with the electroconductive adhesive) thereof gold-plated or treated by gold sputtering. The layered product was heated by a drier (circulation type) at a predetermined temperature (150°C) for 60 minutes to give a coating film that is the electroconductive adhesive sintered.

**[Table 3]**

| Silver fine particles (amine in protective layer) | | | Example 12 | Comparative Example 5 | Comparative Example 6 |
|---|---|---|---|---|---|
| Mixing ratio (part by mass) | 1A | 200 nm (n-Hexylamine) | 24 | 30 | |
| | 1B | 200 nm (3-Methoxypropylamine) | | | 30 |
| | 2A | 75 nm (n-Hexylamine) | 72 | | |
| | 2B | 75 nm (3-Methoxypropylamine) | | | |
| | 2C | 75 nm (Diethyl diaminopropane) | | 60 | 60 |
| | 3A | 20 nm (n-Hexylamine) | 4 | 10 | 10 |
| Average particle diameter (nm) | | | 35 | 26 | 26 |
| Ratio between amines (GC%) | | | HA | HA:DA | MP:HA:DA |
| | | | 100 | 68:32 | 3:51:46 |
| Cracks on coating film | | | None | None | None |
| Shear strength [kgf] | | | 31.3 | 6.7 | 5.5 |

As is clear from the results shown in Table 3, the electroconductive adhesive of Example 12 was high in shear strength of the coating film and had neither cracks nor chips on the coating film at a sintering temperature of 150°C, because while the electroconductive adhesive was obtained by mixing three types of metal fine particles that had different average particle diameters and included the protective layers containing different amines, the mixed types of metal fine particles had an average particle diameter in a range of 30 nm to 300 nm, the amines in the protective layers included a monoalkylamine with 5 to 7 carbon atoms, and the ratio between the monoalkylamine with 5 to 7 carbon atoms and an amine different from these amines was 100 : 0. On the other hand, the electroconductive adhesives of Comparative Examples 5 and 6 where the average particle diameter was under 30 nm were low in shear strength of the coating film.

## Claims

1. An electroconductive adhesive comprising metal fine particles A that include a protective layer containing an amine and have an average particle diameter of 30 nm to 300 nm,
the amine being a monoalkylamine with 5 to 7 carbon atoms,
wherein the metal fine particles A include metal fine particles S containing, as the amine contained in the protective layer, a monoalkylamine with 5 to 7 carbon atoms and having an average particle diameter in a range of 180 nm to 210 nm.

2. The electroconductive adhesive according to claim 1, wherein the protective layer further contains a fatty acid.

3. The electroconductive adhesive according to claim 1 or 2, further comprising a solvent.

4. The electroconductive adhesive according to any one of claims 1 to 3, wherein the metal fine particles A include 15% by mass or less of metal fine particles having an average particle diameter of less than 30 nm relative to the total amount of metal fine particles A.

5. A sintered object of the electroconductive adhesive according to any one of claims 1 to 4.

6. A circuit or an apparatus comprising a part that bonds between members and is the sintered object according to claim 5.

7. A method of manufacturing an electroconductive adhesive, the method comprising a step of mixing metal fine particles A that include a protective layer containing an amine and have an average particle diameter of 30 nm to 300 nm,
in the metal fine particles A used, the amine being a monoalkylamine with 5 to 7 carbon atoms,
wherein the metal fine particles A include metal fine particles S containing, as the amine contained in the protective layer, a monoalkylamine with 5 to 7 carbon atoms and having an average particle diameter in a range of 180 nm to 210 nm, and
further comprising the steps of:
arranging metal fine particles that include a protective layer containing an amine and have an average particle diameter of 30 nm to 300 nm; and
substituting the amine contained in the protective layer of the metal fine particles by the monoalkylamine with 5 to 7 carbon atoms to prepare the metal fine particles A.

8. A method of bonding members comprising the steps of:
disposing the electroconductive adhesive according to any one of claims 1 to 4 between members; and
heating the electroconductive adhesive for sintering.

## Patentansprüche

1. Elektrisch leitfähiges Haftmittel, umfassend Metallfeinpartikel A, die eine Amin enthaltende Schutzschicht aufweisen und einen durchschnittlichen Partikeldurchmesser von 30 nm bis 300 nm aufweisen,
wobei das Amin ein Monoalkylamin mit 5 bis 7 Kohlenstoffatomen ist,
wobei die Metallfeinpartikel A Metallfeinpartikel S umfassen, die als in der Schutzschicht enthaltenes Amin ein Monoalkylamin mit 5 bis 7 Kohlenstoffatomen enthalten und einen mittleren Partikeldurchmesser im Bereich von 180 nm bis 210 nm aufweisen.

2. Elektrisch leitfähiges Haftmittel nach Anspruch 1, wobei die Schutzschicht ferner eine Fettsäure enthält.

3. Elektrisch leitfähiges Haftmittel nach Anspruch 1 oder 2, das ferner ein Lösungsmittel umfasst.

4. Elektrisch leitfähiges Haftmittel nach einem der Ansprüche 1 bis 3, wobei die Metallfeinpartikel A 15 Massenprozent oder weniger an Metallfeinpartikeln mit einem mittleren Partikeldurchmesser von weniger als 30 nm, bezogen auf die Gesamtmenge der Metallfeinpartikel A, einschließen.

5. Sinterkörper aus dem elektrisch leitfähigen Haftmittel gemäß einem der Ansprüche 1 bis 4.

6. Schaltung oder Vorrichtung, die ein Teil umfasst, das zwischen Bauteilen verbindet und der Sinterkörper gemäß Anspruch 5 ist.

7. Verfahren zur Herstellung eines elektrisch leitfähigen Haftmittels, wobei das Verfahren einen Schritt des Mischens von Metallfeinpartikel A umfasst, die eine ein Amin enthaltende Schutzschicht aufweisen und einen mittleren Partikeldurchmesser von 30 nm bis 300 nm aufweisen,
wobei in den verwendeten Metallfeinpartikeln A das Amin ein Monoalkylamin mit 5 bis 7 Kohlenstoffatomen ist,
wobei die Metallfeinpartikel A Metallfeinpartikel S umfassen, die als in der Schutzschicht enthaltenes Amin ein Monoalkylamin mit 5 bis 7 Kohlenstoffatomen enthalten und einen mittleren Partikeldurchmesser im Bereich von 180 nm bis 210 nm aufweisen, und
das ferner die folgenden Schritte umfasst:
das Anordnen von Metallfeinpartikeln, die eine ein Amin enthaltende Schutzschicht aufweisen und einen mittleren Partikeldurchmesser von 30 nm bis 300 nm aufweisen; und
das Ersetzen des in der Schutzschicht der Metallfeinpartikel enthaltenen Amins durch das Monoalkylamin mit 5 bis 7 Kohlenstoffatomen, um die Metallfeinpartikel A herzustellen.

8. Verfahren zum Verbinden von Bauteilen, umfassend die Schritte des:
Aufbringens des elektrisch leitfähigen Haftmittels gemäß einem der Ansprüche 1 bis 4 zwischen Bauteilen; und
Erhitzens des elektrisch leitfähigen Haftmittels zum Sintern.

## Revendications

1. Adhésif électroconducteur comprenant de fines particules métalliques A qui incluent une couche protectrice contenant une amine et ont un diamètre particulaire moyen de 30 nm à 300 nm,
l'amine étant une monoalkylamine avec 5 à 7 atomes de carbone,
dans lequel les fines particules métalliques A incluent de fines particules métalliques S contenant, en tant qu'amine contenue dans la couche protectrice, une monoalkylamine avec 5 à 7 atomes de carbone et ayant un diamètre particulaire moyen dans une plage de 180 nm à 210 nm.

2. Adhésif électroconducteur selon la revendication 1, dans lequel la couche protectrice contient en outre un acide gras.

3. Adhésif électroconducteur selon la revendication 1 ou 2, comprenant en outre un solvant.

4. Adhésif électroconducteur selon l'une quelconque des revendications 1 à 3, dans lequel les fines particules métalliques A incluent 15 % en masse ou moins de fines particules métalliques ayant un diamètre particulaire moyen de moins de 30 nm par rapport à la quantité totale de fines particules métalliques A.

5. Objet fritté de l'adhésif électroconducteur selon l'une quelconque des revendications 1 à 4.

6. Circuit ou appareil comprenant une pièce qui s'assemble entre des éléments et est l'objet fritté selon la revendication 5.

7. Procédé de fabrication d'un adhésif électroconducteur, le procédé comprenant une étape de mélange de fines particules métalliques A qui incluent une couche protectrice contenant une amine et ont un diamètre particulaire moyen de 30 nm à 300 nm,
dans les fines particules métalliques A, l'amine étant une monoalkylamine avec 5 à 7 atomes de carbone,
dans lequel les fines particules métalliques A incluent de fines particules métalliques S contenant, en tant qu'amine contenue dans la couche protectrice, une monoalkylamine avec 5 à 7 atomes de carbone et ayant un diamètre particulaire moyen dans une plage de 180 nm à 210 nm, et
comprenant en outre les étapes consistant à :
agencer de fines particules métalliques qui incluent une couche protectrice contenant une amine et ont un diamètre particulaire moyen de 30 nm à 300 nm ; et
substituer l'amine contenue dans la couche protectrice des fines particules métalliques par la monoalkylamine avec 5 à 7 atomes de carbone pour préparer les fines particules métalliques A.

8. Procédé d'assemblage d'éléments comprenant les étapes consistant à :
disposer l'adhésif électroconducteur selon l'une quelconque des revendications 1 à 4 entre des éléments ; et
chauffer l'adhésif électroconducteur pour frittage.
